# DEMANDE DE BREVET EUROPEEN

(11) **EP 0 992 825 A1**
(43) Date de publication de la demande: **12.04.2000**
(21) Numéro de dépôt: 99402430.5
(22) Date de dépôt: 04.10.1999
(51) Int. Cl.: G02B 6/42, G02B 6/12

(54) **Composant monolithique électro-optique multi-sections.**

(30) Priorité: 05.10.1998 FR 9812456
(71) Demandeur: ALCATEL, 75008 Paris (FR); FRANCE TELECOM, 75015 Paris (FR)
(72) Inventeur: Mallecot, Franck, 94230 Cachan (FR); Chaumont, Christine, 94230 Cachan (FR); Leroy, Arnaud, 94230 Cachan (FR); Plais, Antonina, 94230 Cachan (FR); Nakajima, Hisao, 94230 Cachan (FR)
(74) Mandataire: Ballot, Paul

(57) **Abrégé**

L' invention concerne un composant monolithique électro-optique en semi-conducteur comprenant au moins des première et deuxième sections (20, 30) ayant chacune respectivement un premier guide d'onde (21) et un deuxième guide d'onde (31) émetteur de lumière, lesdits guides d'onde étant gravés sous forme de rubans et confinés entre une couche de gaine (11) supérieure dopée en porteurs d'un premier type et une couche inférieure (10A, 10B) dopée en porteurs d'un deuxième type, une troisième section (40) étant disposée entre lesdites première et deuxième sections (20, 30) et comportant un troisième guide non-émetteur de lumière, ledit troisième guide étant disposé de façon à coupler ledit premier guide (21) audit second guide (31), caractérisé en ce qu'une couche absorbante (70), ayant une longueur d'onde de photoluminescence au moins égale à la longueur d'onde la plus basse des ondes se propageant dans lesdits premier et deuxième guides d'onde (21, 31), est placée dans ladite couche inférieure (10A, 10B) dopée en porteurs du deuxième type ; ladite couche inférieure (10A, 10B) ayant un indice inférieur à celui de la couche absorbante (70) et à celui desdits deuxième et troisième guides (31).

## Description

La présente invention se rapporte à un composant monolithique électro-optique en semi-conducteur comprenant au moins deux sections ayant chacune un guide d'onde gravé sous la forme d'un ruban et enterré dans une couche de gaine.

Pour ce type de composant électro-optique multisections à ruban enterré, il est important d'avoir une isolation électrique élevée entre chaque section afin d'éviter des interactions entre celles-ci au cours du fonctionnement du composant. L'invention se rapporte plus particulièrement à tout composant électro-optique, comprenant au moins un élément émetteur et un élément récepteur intégrés, pour lequel on cherche à permettre un fonctionnement en émission-réception simultané, sans aucune interaction entre l'émetteur et le récepteur.

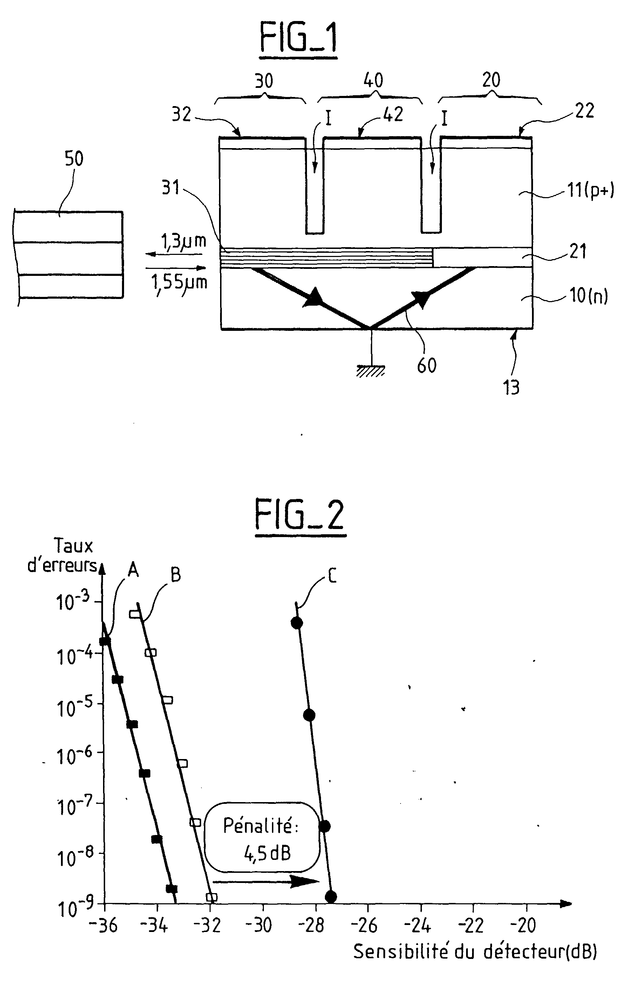

La figure 1 représente un schéma en coupe longitudinale d'un composant émetteur-récepteur en ligne classique, noté 1D-TRD ("In-line Transmitter Receiver Device" en littérature anglo-saxonne), obtenu par intégration monolithique d'un laser 30 et d'un détecteur 20 sur un même substrat 10. Le laser 30 émet un signal vers une fibre optique 50 par exemple, tandis que le détecteur 20 reçoit un signal en provenance de cette même fibre optique. La longueur d'onde d'émission du laser 30 est inférieure à la longueur d'onde de réception du détecteur 20. Par exemple, la longueur d'onde d'émission est égale à 1,3 µm tandis que la longueur d'onde de réception est égale à 1,55 µm. Dans ce cas, étant donné que la longueur d'onde d'émission est inférieure à la longueur d'onde de réception, et que le laser 30 est situé à proximité du détecteur 20, le laser peut amener des perturbations optiques sur le détecteur. En effet, le laser émet aussi, en direction du détecteur, de la lumière à 1,3 µm qui vient éblouir ce-dernier. Pour éviter cet éblouissement du détecteur, le composant comporte une troisième section, disposée entre le laser 30 et le détecteur 20, formant un isolant optique 40. Cet isolant optique permet d'absorber la lumière émise à 1,3 µm en direction du détecteur, de manière à ce que ce-dernier puisse détecter le signal optique à 1,55 µm en provenance de la fibre optique sans être perturbé par le laser.

Le substrat 10, ou couche inférieure, peut par exemple être de l'Inp dopé n. Les guides d'ondes respectivement 21 du détecteur 20 et 31 du laser 30 et de l'isolant optique 40 sont gravés sous forme de rubans et enterrés dans une couche de gaine 11 fortement dopée. Les guides d'onde sont dits de type BRS ("Buried Ridge Structure" en littérature anglosaxonne). Le matériau de gaine 11 est dopé p+ lorsque le substrat est dopé n. Bien sûr, ce type de ruban n'est qu'un exemple. D'autres types de rubans peuvent convenir. Les dopages n et p des différentes couches peuvent en outre être inversés.

Il existe de nombreuses variantes de compositions et de dimensions des guides d'onde. Dans l'exemple de la figure 1, le guide d'onde 21 du détecteur 20 est par exemple réalisé en matériau ternaire, alors que les guides d'onde 31 du laser et de l'isolant optique 40 sont réalisés avec une même structure à puits quantiques.

D'autre part, des électrodes métalliques 22, 32, 42 et 13 sont formées sur les différentes sections et sur le dessous du composant, de manière à permettre son fonctionnement.

Du fait de la présence de couches conductrices (11), le composant comporte en outre des zones d'isolation électrique I, ou zones résistives, entre les différentes sections 20, 30, 40 afin d'éviter toute perturbation électrique d'une section vis à vis d'une autre lors du fonctionnement du composant.

Ce type d'émetteur-récepteur en ligne, comportant une partie centrale 40 permettant d'absorber tout le flux de lumière émis à 1,3 µm vers le détecteur, fonctionne très bien pour toute la lumière qui est guidée dans les rubans de guides d'onde 31.

Cependant, la totalité de la lumière émise n'est pas entièrement guidée. En effet, il existe aussi de la lumière spontanée qui est émise dans tout le volume du composant. De plus, une partie de la lumière stimulée peut aussi être diffractée dans le composant du fait de la présence de défauts dans le guide d'onde 31.

Les courbes de la figure 2 mettent en évidence les pénalités constatées sur la sensibilité du détecteur, en dB, pour différents indices de fonctionnement. La courbe A représente une référence en réception lorsque le laser est éteint, la courbe B représente une référence en réception lorsque le laser est allumé en continu et la courbe C représente la modulation simultanée du laser et du détecteur. On constate une pénalité de 4,5 dB entre la courbe B et la courbe C, lorsque l'on module simultanément le laser et le détecteur. Cette pénalité est principalement optique. Elle est causée par la lumière non guidée émise à 1,3µm, dans toutes les directions, qui vient perturber le détecteur à 1,55µm. Cette lumière parasite attaque le détecteur essentiellement par le dessous (substrat) du composant, c'est à dire par la couche inférieure 10 dopée n située sous les rubans de couches guidantes 21, 31.

Cette perturbation optique provenant du substrat 10 est représentée très schématiquement sur la figure 1. Une électrode métallique 13, disposée à l'interface substrat-air, peut jouer un rôle de réflecteur optique. Une partie de la lumière spontanée émise dans le volume du composant peut donc être réfléchie par l'électrode 13 et revenir se coupler au détecteur 20 par en dessous. C'est pourquoi la lumière parasite, qui se couple via le substrat du composant, a été représentée, sur la figure 1, par une onde 60 réfléchie sur l'électrode métallique 13 du substrat. Bien sûr, la perturbation du détecteur 20 par la lumière non guidée est en réalité bien plus complexe qu'une simple réflexion. En effet, une partie de la lumière parasite peut en outre subir de multiples réflexions dans la couche inférieure 10. Une autre partie de cette lumière parasite peut également venir éblouir le détecteur en incidence rasante par exemple.

Des techniques ont déjà été envisagées pour combattre la pénalité, de 4,5 dB constatée dans l'exemple donné figure 2, qui se produit lors de la modulation simultanée du laser et du détecteur. Les techniques envisagées sont des techniques électroniques. Elles consistent par exemple à prélever une partie du signal de modulation laser, puis à le soustraire en réception. L'utilisation de ces techniques de traitement électronique a démontré une réduction de 2 dB de la pénalité. Cependant elles nécessitent la mise au point, la fabrication et le développement d'une électronique spécifique pour ce type de composant émetteur-récepteur particulier, si bien qu'elles augmentent considérablement le coût de ce composant. Or, on recherche à fabriquer ce type de composant à grande échelle et donc à réduire au maximum son prix de revient. Par conséquent, ces techniques de traitement électronique ne peuvent pas être mises en oeuvre pour la fabrication en masse d'un tel composant.

De plus, un émetteur-récepteur en ligne est destiné à être installé chez des abonnés et il doit pouvoir fonctionner entre environ 0 et 70 °C sans aucune régulation en température. Or, la fiabilité de ces techniques électroniques n'a pas été démontrée sur cette gamme de températures et il n'est pas prouvé qu'elles puissent s'ajuster automatiquement en fonction de la température.

Un but de la présente invention consiste donc à réaliser un composant monolithique électro-optique peu coûteux comportant un détecteur et un élément parasite pour le détecteur, tel qu'un laser, la longueur d'onde d'émission étant inférieure à la longueur d'onde de réception, dans lequel la perturbation de 4,5 dB du détecteur par l'élément parasite (selon l'exemple de la figure 2), qui se produit lors de leur modulation simultanée, est considérablement réduite.

La présente invention se rapporte plus particulièrement à un composant monolithique électro-optique en semi-conducteur comprenant au moins des première et deuxième sections ayant chacune respectivement un premier guide d'onde et un deuxième guide d'onde émetteur de lumière, lesdits guides d'onde étant gravés sous forme de rubans et confinés entre une couche de gaine supérieure dopée en porteurs d'un premier type et une couche inférieure dopée en porteurs d'un deuxième type, une troisième section étant disposée entre lesdites première et deuxième sections et comportant un troisième guide non-émetteur de lumière, ledit troisième guide étant disposé de façon à coupler ledit premier guide audit second guide, caractérisé en ce qu'une couche absorbante, ayant une longueur d'onde de photoluminescence au moins égale à la longueur d'onde la plus basse des ondes se propageant dans lesdits premier et deuxième guides d'onde, est placée dans ladite couche inférieure dopée en porteurs du deuxième type ; ladite couche inférieure ayant un indice inférieur à celui de la couche absorbante et à celui desdits deuxième et troisième guides.

L'invention exploite le fait que si une onde parasite issue du deuxième guide et atteignant la couche absorbante n'est pas totalement absorbée par celle-ci, elle subit une réflexion partielle due au gradient d'indice entre la couche absorbante et la couche supérieure. La partie réfléchie de cette onde est alors dirigée (au moins partiellement) vers le second ou le troisième guide qui à son tour la réfléchit vers la couche absorbante.

Comme ce phénomène se produit sur une distance correspondant la longueur des deuxième et troisième guides, on obtient une absorption répartie sur cette longueur.

Ceci a pour conséquence que l'épaisseur de la couche absorbante peut être réduite,par rapport au cas où la même énergie lumineuse devrait être absorbée par une seule (ou un nombre limité) de traversée (s) de la couche absorbante. Le fait de ne nécessiter qu'une faible épaisseur implique 'un temps de fabrication réduit et surtout un risque moindre de faire apparaître des défauts dans la couche absorbante.

Ainsi, la couche absorbante a une épaisseur inférieure à 2 µm et supérieure à 0,2 µm.

Avantageusement, l'épaisseur est comprise entre 0,2 et 1 µm.

D'autre part, l'absorption sera d'autant plus efficace que la longueur d'absorption est grande.

On a pu établir expérimentalement qu'une bonne efficacité était obtenue si la longueur du troisième guide était supérieure à 100 µm environ.

Ce sera en particulier le cas pour les émetteurs-récepteurs qui sont munis d'une troisième section isolante dont la longueur est typiquement de l'ordre de 300 µm.

Selon une autre caractéristique de l'invention, la couche absorbante est dopée en porteurs du deuxième type.

Selon une autre caractéristique de l'invention, la couche absorbante est disposée à une distance des guides d'onde telle qu'elle n'interagit pas avec le guide d'onde émettant la lumière non guidée. Cette distance est de préférence supérieure à 1 µm.

Selon une autre caractéristique de l'invention, ce composant constitue un émetteur-récepteur en ligne dont la longueur d'onde d'émission est inférieure à la longueur d'onde de réception.

Selon encore une autre caractéristique de l'invention, les porteurs du premier type sont des porteurs de type p, et les porteurs du deuxième type sont des porteurs de type n.

D'autres particularités et avantages de l'invention apparaîtront à la lecture de la description donnée à titre d'exemple illustratif et faite en référence aux figures annexées qui représentent :
- la figure 1 déjà décrite, un schéma d'un émetteur-récepteur en ligne classique,
- la figure 2, déjà décrite, des courbes permettant de mettre en évidence les pénalités de fonctionnement lors d'une modulation simultanée de l'émetteur et du récepteur du composant de la figure 1,
- la figure 3, un schéma d'un exemple de composant émetteur-récepteur selon l'invention.

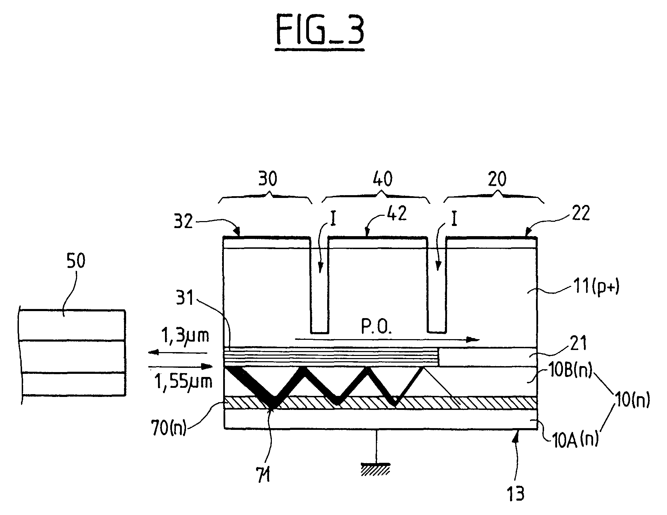

La figure 3 schématise un mode de réalisation d'un composant selon l'invention. Il schématise plus particulièrement un émetteur-récepteur en ligne. Mais l'invention ne se limite pas seulement aux émetteurs-récepteurs en ligne, elle s'applique à tout composant opto-électronique intégré pour lequel il existe une diaphonie optique, c'est à dire à tout composant comprenant un élément parasite et un élément apte à détecter pour lequel les longueurs d'onde émises et reçues sont compatibles.

Dans cet exemple, les mêmes références sont utilisées pour désigner les mêmes éléments que dans l'émetteur-récepteur classique schématisé sur la figure 1. Le laser 30 émet à une longueur d'onde inférieure à la longueur d'onde de réception du détecteur 20. La longueur d'onde d'émission est par exemple égale à 1,3 µm alors que la longueur d'onde de réception est égale à 1,55 µm.

La lumière spontanée émise par le laser 30 et non guidée par le guide d'onde 31 est émise dans tout le volume du composant. De plus, une partie,de la lumière stimulée est diffractée dans le composant du fait de la présence de défauts dans le guide d'onde 31. Toutes ces ondes lumineuses parasites émises à 1,3µm par le laser 30, dans toutes les directions, viennent perturber et éblouir le détecteur qui ne peut plus détecter correctement la longueur d'onde à 1,55 µm. Ces perturbations sont schématisées simplement par la flèche P.O (Perturbations Optiques) sur la figure 3. Elles proviennent essentiellement du dessous du composant émetteur-récepteur, c'est à dire par les couches situées en dessous des guides d'onde 21, 31. Cette perturbation entraîne une pénalité de 4,5 dB (selon l'exemple cité figure 2) lors d'une modulation simultanée du laser 30 et du détecteur 20.

Afin d'éliminer cette lumière parasite non guidée émise à 1,3 µm, l'émetteur-récepteur selon l'invention comprend une couche absorbante 70 qui est placée dans la couche inférieure dopée n du composant.

Cette couche absorbante 70 est réalisée de préférence en matériau ternaire. Elle est déposée par exemple sur le substrat 10A en InP dopé n et elle est recouverte, par exemple, par une couche tampon 10B en InP dopé n. Le substrat 10A et la couche tampon 10B forment deux parties de la couche inférieure 10 dopée n du composant. La couche absorbante 70 est par ailleurs dopée par le même type de porteurs que le substrat 10A et la couche tampon 10B afin d'éviter la création de jonctions parasites dans la partie inférieure du composant. Dans l'exemple, la couche absorbante 70 est donc dopée n. Bien sûr, ceci n'est qu'un exemple; le composant selon l'invention peut très bien comporter des couches dont le dopage est inversé. Ainsi, il peut comporter une couche de gaine dopée n et une couche inférieure dopée p comportant une couche absorbante dopée p.

Grâce à la couche absorbante 70, il a été montré expérimentalement que la pénalité qui existe lorsque l'on module simultanément le laser et le détecteur est réduite de 3dB. La pénalité restante de 1,5 dB est en fait essentiellement due aux effets de guidage des guides d'onde.

La couche absorbante 70 absorbe la lumière parasite non guidée émise à 1,3 µm. Mais elle ne doit pas absorber le mode guidé du laser 30. Par conséquent, il est nécessaire de placer la couche absorbante 70 à une distance des guides d'ondes 21, 31 telle qu'elle n'interagit pas de façon significative avec le mode guidé du laser. Cette distance est de préférence supérieure à 1 µm. Dans un exemple de réalisation, on la place à une distance de 3µm au dessous des guides d'onde 21 et 31.

L'onde lumineuse 71 absorbée par la couche absorbante 70 entre le laser 30 et le détecteur 20 est représentée de manière très schématique sur la figure 3. En effet, du fait des différences d'indices de réfraction entre le guide d'onde 31 du laser, la couche tampon 10B et la couche absorbante 70, la lumière spontanée non guidée subit de multiples réflexions, et elle est absorbée par la couche absorbante 70 au fur et à mesure qu'elle se propage vers le détecteur 20. Mais, bien sûr, la lumière émise n'est pas seulement réfléchie entre ces couches, elle peut aussi subir d'autres réflexions dans toutes les couches inférieures du composant, c'est à dire dans la couche tampon 10B et/ou la couche absorbante 70 et/ou le substrat 10A et/ou l'électrode métallisée 13. En fait, la propagation de la lumière parasite non guidée se fait, dans toutes les directions, dans toutes les couches du dessous du composant, situées sous les guides d'onde 21 et 31. Ainsi, la lumière parasite est absorbée au fur et à mesure de sa propagation, de telle sorte qu'elle devient très faible, voire nulle, avant d'atteindre le détecteur 20. Le détecteur 20 n'est donc plus perturbé par les ondes parasites émises à 1,3 µm.

## Revendications

1. Composant monolithique électro-optique en semi-conducteur comprenant au moins des première et deuxième sections (20, 30) ayant chacune respectivement un premier guide d'onde (21) et un deuxième guide d'onde (31) émetteur de lumière, lesdits guides d'onde étant gravés sous forme de rubans et confinés entre une couche de gaine (11) supérieure dopée en porteurs d'un premier type et une couche inférieure (10A, 10B) dopée en porteurs d'un deuxième type, une troisième section (40) étant disposée entre lesdites première et deuxième sections (20, 30) et comportant un troisième guide non-émetteur de lumière, ledit troisième guide étant disposé de façon à coupler ledit premier guide (21) audit second guide (31), caractérisé en ce qu'une couche absorbante (70), ayant une longueur d'onde de photoluminescence au moins égale à la longueur d'onde la plus basse des ondes se propageant dans lesdits premier et deuxième guides d'onde (21, 31), est placée dans ladite couche inférieure (10A, 10B) dopée en porteurs du deuxième type ; ladite couche inférieure (10A, 10B) ayant un indice inférieur à celui de la couche absorbante (70) et à celui desdits deuxième et troisième guides (31).

2. Composant monolithique selon la revendication 1, caractérisé en ce que la couche absorbante a une épaisseur inférieure à 2 µm et supérieure à 0,2 µm.

3. Composant selon la revendication 2, caractérisé en ce que l'épaisseur de la couche absorbante (70) est comprise entre 0,2 µm et 1 µm.

4. Composant selon l'une des revendications précédentes caractérisé en ce que la longueur du troisième guide d'onde est supérieure à 100 µm environ.

5. Composant selon la revendication 1, caractérisé en ce que la couche absorbante (70) est dopée en porteurs du deuxième type.

6. Composant selon l'une des revendications 1 à 2, caractérisé en ce que la couche absorbante (70) est réalisée dans un matériau ternaire.

7. Composant selon l'une des revendications 1 à 3, caractérisé en ce que la couche absorbante (70) est disposée en dessous des guides d'onde (21, 31), à une distance telle qu'elle n'interagit pas avec le guide d'onde (31) émettant la lumière non guidée dans la couche inférieure dopée en porteurs du deuxième type.

8. Composant selon la revendication 4, caractérisé en ce que la distance entre la couche absorbante (70) et les guides d'onde (21, 31) est supérieure à 1 µm.

9. Composant selon l'une des revendication 1 à 5, caractérisé en ce qu'il constitue un émetteur-récepteur en ligne dont la longueur d'onde d'émission est inférieure à la longueur d'onde de réception.

10. Composant selon les revendications 1 et 2, caractérisé en ce que les porteurs du premier type sont des porteurs de type p et en ce que les porteurs du deuxième type sont des porteurs de type n.
